# EUROPÄISCHE PATENTSCHRIFT

(11) **EP 1 440 476 B1**
(45) Veröffentlichungstag und Bekanntmachung des Hinweises auf die Patenterteilung: **13.02.2008**
(21) Anmeldenummer: 02779174.8
(22) Anmeldetag: 24.10.2002
(51) Int. Cl.: H01L 31/00, H01L 27/146

(54) **VERFAHREN ZUR HERSTELLUNG EINER PHOTODIODENKONTAKTIERUNG FÜR EINEN TFA-BILDSENSOR**
METHOD FOR PRODUCING A PHOTODIODE CONTACT FOR A TFA IMAGE SENSOR
PROCEDE POUR PRODUIRE UNE MISE EN CONTACT DE PHOTODIODE POUR CAPTEUR D'IMAGE TFA

(30) Priorität: 29.10.2001 DE 10152776
(43) Veröffentlichungstag der Anmeldung: 28.07.2004
(73) Patentinhaber: STMicroelectronics N.V., 1118 BH Schiphol Airport Amsterdam (NL)
(72) Erfinder: RIEVE, Peter, 51570 Windeck-Dattenfeld (DE); SEIBEL, Konstantin, 57074 Siegen (DE); WAGNER, Michael, 01900 Bretnig-Hauswalde (DE)
(74) Vertreter: Hudler, Frank
(86) Internationale Anmeldenummer: PCT/DE2002/004008
(87) Internationale Veröffentlichungsnummer: WO 2003/038908

(56) Entgegenhaltungen:
- EP-A- 1 045 450
- EP-A- 1 050 907
- EP-A- 1 412 987
- SCHULTE J ET AL: "Intelligent image sensor for on-chip contour extraction" PROCEEDINGS OF THE SPIE, SPIE, BELLINGHAM, VA, US, Bd. 2247, 22. Juni 1994 (1994-06-22), Seiten 292-300, XP002080272 ISSN: 0277-786X

## Beschreibung

Die Erfindung betrifft ein Verfahren zur Herstellung einer Photodiodenkontaktierung für einen TFA-Bildsensor mit einem CMOS-ASIC-Schaltkreis, der mit einem Zwischenmetall-Dielektrikum beschichtet worden ist und der in einem photoaktiven Bereich Vias im Pixelraster aufweist, die sich durch das zwischenmetall-Dielektrikum erstrecken und jeweils mit einer Leiterbahn des CMOS-ASIC-Schaltkreises verbunden sind, wobei auf dem zwischenmetall-Dielektrikum eine im Pixelraster strukturierte CMOS-Metallisierung zwischen Barriereschichten angeordnet ist.

Mit einem derartigen optoelektronischen Bauelement wird elektromagnetische Strahlung in einen intensitätsabhängigen Photostrom umgewandelt. Ein derartiger TFA-Sensor (Thin Film-on-ASIC-Sensor) besteht aus einer matrixorganisierten oder linearen Anordnung von Bildpunkten (Pixeln). Die elektronischen Schaltungen zum Betrieb des Sensors (z. B. Pixelelektronik, Peripherieelektronik, Systemelektronik) sind üblicherweise in CMOS-basierter Siliziumtechnologie realisiert und bilden einen anwendungsspezifischen integrierten Schaltkreis (ASIC). Durch eine isolierende Schicht hiervon getrennt und mittels entsprechender elektrischer Kontakte hiermit verbunden, befindet sich auf dem ASIC eine Mehrschichtanordnung als Photodiode, welche die Umwandlung elektromagnetischer Strahlung in einen intensitätsabhängigen Photostrom vornimmt. Dieser Photostrom wird an bestimmten, in jedem Pixel vorhandenen Kontakten über die Vias (Durchkontaktierungen) der darunterliegenden Pixelelektronik übergeben (B. Schneider, P. Rieve, M. Böhm, Image Sensors in TFA (Thin Film on ASIC) Technology, ed. B. Jähne, H. Hausecker, P. Geißler, Handbook of Computer Vision and Applications, pp. 237-270, Academic Press, San Diego, 1999). Die die Photodiode bildende Mehrschichtanordnung auf der Basis von hydrogenisiertem amorphem Silizium (a-Si:H) besteht beispielsweise aus einer unteren n-Type a-Si:H Schicht, einer intrinsic a-Si:H-Schicht sowie einer p-Type a-Si:H-Schicht. Die auf dieser Mehrschichtanordnung befindliche transparente leitfähige Kontaktschicht dient als Frontelektrode für die Photodiode.

Eine solche Mehrschichtanordnung wird in "J. A. Theil, M. Cao, G. Kooi, G. W. Ray, W. Greene, J. Lin, AJ. Budrys, U. Yoon, S. Ma, H. Stork, Hydrogenated Amorphous Silicon Photodiode Technology for Advanved CMOS Active Pixel Sensor Imagers, MRS Symposium Proceedings, vol. 609, 2000" beschrieben. Die Photodiode wird hier durch eine pin-Konfiguration auf der Basis amorphen Siliziums gebildet, d. h. durch eine Folge aus einer p-leitenden, einer eigenleitenden (intrinsischen) und einer n-leitenden amorphen Siliziumschicht. Die n-Schicht bildet üblicherweise die unterste, dem ASIC zugewandte Schicht. Die elektrischen Kontakte werden auf dieser dem ASIC zugewandten Seite beispielsweise von einer strukturierten Metallschicht gebildet, während die Kontaktierung auf der der Lichteinfallsrichtung zugewandten Seite in der Regel durch die transparente und leitfähige Schicht erfolgt.

Über die genannte pin-Photodiode hinaus sind auch andere Bauelementstrukturen möglich, z. B. Schottky-Photodioden oder auch Bauelemente mit einer steuerbaren spektralen Empfindlichkeit (P. Rieve, M. Sommer, M. Wagner, K. Seibel, M. Böhm, a-Si:H Color Imagers and Colorimetry, Journal of Non-Crystalline Solids, vol. 266-269, pp. 1168-1172, 2000). Diese Grundstruktur kann ferner durch zusätzliche, in Lichteinfallsrichtung vorgelagerte Schichten erweitert werden, beispielsweise durch Farbfilterschichten (z. B. Bayer-Pattern, US-Patent Nr. 3971065).

Die Art der elektrischen Kontaktierung der Photodioden zum CMOS-Pixelschaltkreis und insbesondere die Wahl der daran beteiligten Materialien sind von entscheidender Bedeutung in bezug auf die Kenngrößen der Photodiode, speziell auf deren Dunkelstrom.

Aus SCHULTE J ET AL: "Intelligent image sensor for on-chip contour extraction" PROCEEDINGS OF THE SPIE, SPIE, BELLING-HAM, VA, US, Bd. 2247, 22. Juni 1994 (1994-06-22), Seiten 292-300, XP002080272 ISSN: 0277-786X geht ein Image Sensor hervor, bei dem der kristalline ASIC von den amorphen Dünnschichten durch einen strukturierten Isolator getrennt ist. Der Isolator ist mit pixelweisen Durchkontaktierungen versehen, die unten mit Rückkontakten mit dem ASIC verbunden sind. Auf dem Isolator befindet sich eine pixelweise Metallisierung, die durch Gräben voneinander getrennt sind. Jede Metallisierung und der Boden des Grabens sind mit einer n-leitenden Schicht (n-a-Si:H) abgedeckt. Darüber befindet sich eine pixelübergreifende eigenleitende amorphe Si-Schicht (i-a-Si:H) und über dieser eine p-leitende Schicht (p-a-Si:H), die wiederum von einer TCO-Schicht abgedeckt wird.

Mit einer solchen Anordnung lässt sich eine Verringerung des Dunkelstroms nicht erreichen.

Die EP-A1-1 050 907 bezieht sich auf eine Photosensor Struktur mit einer gestapelten Pixelstruktur mit mehreren übereinander liegenden Photosensoren. Die für einen geringen. Dunkelstrom notwendige flache Struktur lässt sich bei einem solchen Photosensor ebenfalls nicht realisieren.

Der Erfindung liegt die Aufgabe zugrunde, ein Verfahren zum Herstellen einer Photodiodenkontaktierung für einen TFA-Bildsensor zu schaffen, welches im Hinblick auf die Kenngrößen der Photodiode optimiert ist und gleichzeitig technologisch möglichst einfach realisiert werden kann. Eine weitere Randbedingung stellt die Forderung nach einer im Vergleich zur Dicke der Photodiode flachen Oberflächentopographie dar, welche im Hinblick auf einen niedrigen Dunkelstrom unerlässlich ist.

Die der Erfindung zugrundeliegende Aufgabe wird bei einem Verfahren der eingangs genannten Art gelöst durch Freilegen der CMOS-Metallisierung innerhalb des photoaktiven Bereiches, Herstellen einer flachen Oberflächentopographie auf dem Zwischenmetall-Dielektrikum, indem mindestens die auf dem CMOS-ASIC-Schaltkreis befindliche CMOS-Metallisierung sowie die auf dieser befindliche Barriereschicht im photoaktiven Bereich bis mindestens auf die strukturierte untere Barriereschicht entfernt wird, und anschließendes Aufbringen eines an sich bekannten amorphen oder monokristallinen Siliziums sowie darüber einer an sich bekannten leitfähigen transparenten Kontaktschicht auf dem Zwischenmetall-Dielektrikum.

Dadurch wird eine im Hinblick auf die Kenngrößen der Photodiode optimierte Photodiodenkontaktierung realisiert, was zudem mit relativ einfachen technologischen Mitteln erreicht wird.

In Fortführung der Erfindung kann im Bereich des photoaktiven Bereiches die CMOS-Metallisierung und zusätzlich die unter dieser befindliche Barriereschicht entfernt werden, so dass das Zwischenmetall-Dielektrikum mit den darin eingebeteten Vias frei liegt und danach das amorphe oder monokristalline Silizium und die leitfähige transparente Kontaktschicht aufgebracht werden. In diesem Fall bilden die Vias die Rückelektroden der Photodioden.

Eine weitere Verbesserung der Kenngrößen der Photodiode wird erreicht, wenn auf dem Zwischenmetall-Dielektrikum, oder der strukturierten Barriereschicht eine im Pixelraster strukturierte Metallschicht, vorzugsweise aus Chrom, oder einer Chromlegierung, aufgebracht wird. In diesem fall bildet die strukturierte Metallschicht die Rückelektroden der Photodioden.

Alternativ kann auf dem zwischenmetall-Dielektrikum, oder der strukturierten Barriereschicht auch eine im Pixelraster strukturierte dotierte Schicht aus Silizium aufgebracht wird. Diese Schicht kann als dotierte Schicht aus amorphem Silizium, einem mikrokristallinem Silizium oder Legierungen davon hergestellt werden. In diesem Fall bildet die strukturierte dotierte Siliziumschicht die Rückelektroden der Photodioden.

In einer weiteren vorteilhaften Variante des erfindungsgemäßen Verfahrens wird die dotierte Schicht aus Silizium nach dem Aufbringen der im Pixelraster strukturierten Metallschicht aufgebracht.

Die Erfindung soll nachfolgend an mehreren Ausführungsbeispielen näher erläutert werden. In den zugehörigen Zeichnungen zeigen:
- Fig. 1:: eine schematische Darstellung eines mit einem Zwischenmetall-Dielektrikum versehenen ASIC-Schaltkreises in CMOS-Technologie mit freiliegender oberster Metallisierung;
- Fig. 2:: den ASIC-Schaltkreis nach Fig. 1, bei dem die oberste CMOS-Metallisierung mit Ausnahme der unteren Barriereschicht entfernt worden ist;
- Fig. 3:: den ASIC-Schaltkreis nach Fig. 2, bei dem im photoaktiven Bereich die Mehrschichtanordnung der Photodiode aus amorphem oder mikrokristallinem Silizium oder deren Legierungen auf der strukturierten Barriereschicht abgeschieden worden sind;
- Fig. 4:: den ASIC-Schaltkreis nach Fig.1, bei dem im photoaktiven Bereich die oberste Metallisierung inclusive der Barriereschicht entfernt worden ist ;
- Fig. 5:: den ASIC-Schaltkreis nach Fig. 4, bei dem die Mehrschichtanordnung der Photodiode im photoaktiven Bereich aus amorphem oder mikrokristallinem Silizium oder deren Legierungen direkt auf dem Zwischemetall-Dielektrikum mit den darin eingebetteten Vias des ASIC-Schaltkreises abgeschieden worden ist;
- Fig. 6:: den ASIC-Schaltkreis nach Fig. 4, bei dem auf einer Anordnung von Vias eine weitere Metallschicht abgeschieden wurde, die im Pixelraster strukturiert ist;
- Fig. 7:: den ASIC-Schaltkreis nach Fig. 6, bei dem die Mehrschichtanordnung der Photodiode im photoaktiven Bereich aus amorphem oder mikrokristallinem Silizium oder deren Legierungen direkt auf der weiteren Metallschicht abgeschieden worden ist;
- Fig. 8:: den ASIC-Schaltkreis nach Fig. 4, bei dem auf einer Anordnung von Vias eine dotierte Siliziumschicht abgeschieden wurde, die im Pixelraster strukturiert ist; und
- Fig. 9:: den ASIC-Schaltkreis nach Fig. 8, bei dem die Mehrschichtanordnung der Photodiode im photoaktiven Bereich aus amorphem oder mikrokristallinem Silizium oder deren Legierungen direkt auf der dotierten Siliziumschicht abgeschieden worden ist.

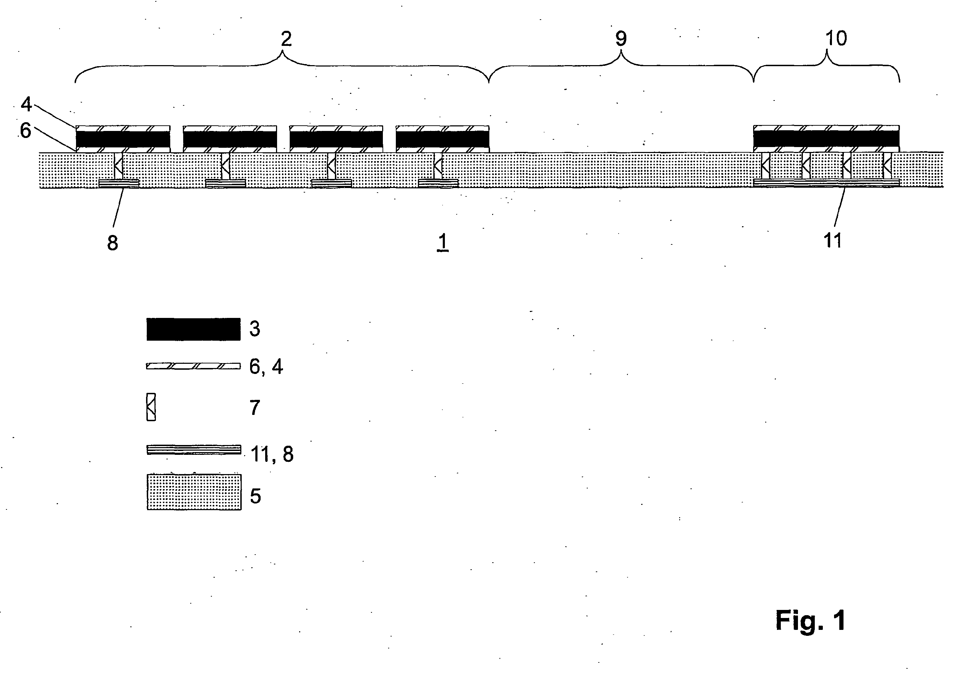

Fig. 1 zeigt zunächst eine beispielhafte schematische Darstellung eines zur Herstellung eines TFA-Bildsensors vorgesehenen handelsüblichen CMOS-ASIC Schaltkreises 1, bei dem zunächst innerhalb eines photoaktiven Bereiches 2 die oberste CMOS-Metallisierung 3 (Metall 2) freigelegt worden ist, in dem eine nicht dargestellte CMOS-Passivierungsschicht z.B. durch Ätzen entfernt worden ist. Dieser CMOS-ASIC-Schaltkreis 1 weist aber, abgesehen von dieser obersten CMOS-Metallisierung 3 im photoaktiven Bereich 2 (Pixelbereich) eine flache Oberflächentopographie auf. Die CMOS-Metallisierung 3, die mittels photolithographischer Verfahren im Pixelraster strukturiert worden ist, ist mit einer dünnen Barriereschicht 4 abgedeckt und auf einem Zwischenmetall-Dielektrikum 5 des CMOS-ASIC-Schaltkreises 1 angeordnet, wobei sich zwischen der CMOS-Metallisierung 3 und dem Zwischenmetall-Dielektrikum 5 eine weitere dünne Barriereschicht 6 befindet. Die im Pixelraster strukturierte Metall- und Barriereschicht 4, 5, 6 ist über Vias 7 (Durchkontaktierungen) mit darunterliegenden Leiterbahnen 8 (Metall 1) elektrisch leitend verbunden.

Weiterhin ist in Fig. 1 ein Bereich der Peripherieelektronik 9, sowie ein Bondpad 10 zur Realisierung einer Außenkontaktierung dargestellt. Das Bondpad 10 wurde ebenfalls mittels photolithographischer Verfahren aus der CMOS-Metallisierung 3 (Metall 2) strukturiert und ist über Via's 7 mit einer darunter liegenden Leiterbahn 11 (Metall 1) des CMOS-ASIC-Schaltkreises verbunden.

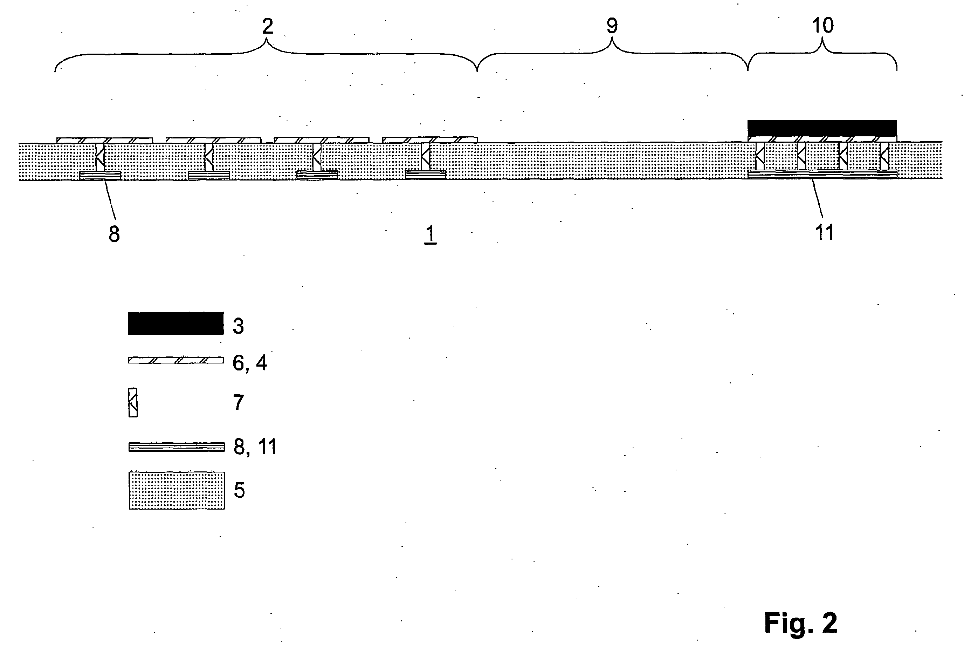

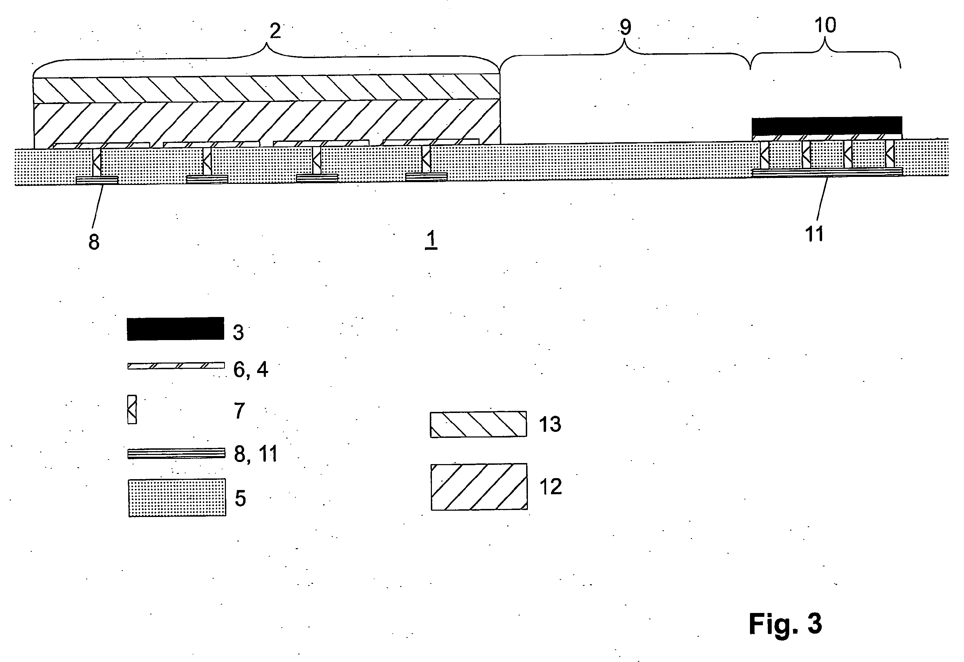

Nach dem erfindungsgemäßen Verfahren wird zur Realisierung der Photodiodenkontakte die oberste CMOS-Metallisierung 3, welche in der Regel aus einem Mehrschichtsystem besteht, bis auf die untere dünne Barriereschicht 6 aus beispielsweise Titannitrid (TiN) entfernt (Fig. 2). Diese Barriereschicht 6 ist über ein oder mehrere Vias 7 z. B. in Form sogenannter Wolfram-Plugs (W-Plug) mit dem CMOS-ASIC-Schaltkreis verbunden. Die nach Abtragen der darüberliegenden Metall-Lagen verbleibenden Strukturen der Barriereschicht 6 (z. B. TiN), welche eine im Vergleich zur Photodiode geringe Dicke aufweisen, werden als Pixelrückelektroden verwendet, d. h. auf sie wird die Photodiode aus amorphem oder mikrokristallinem Silizium 12 oder deren Legierungen und eine Kontaktschicht 13 aufgetragen (Fig. 3). Dieser Schichtaufbau kann einfach mittels üblicher CVD- oder PVD-Verfahren erfolgen.

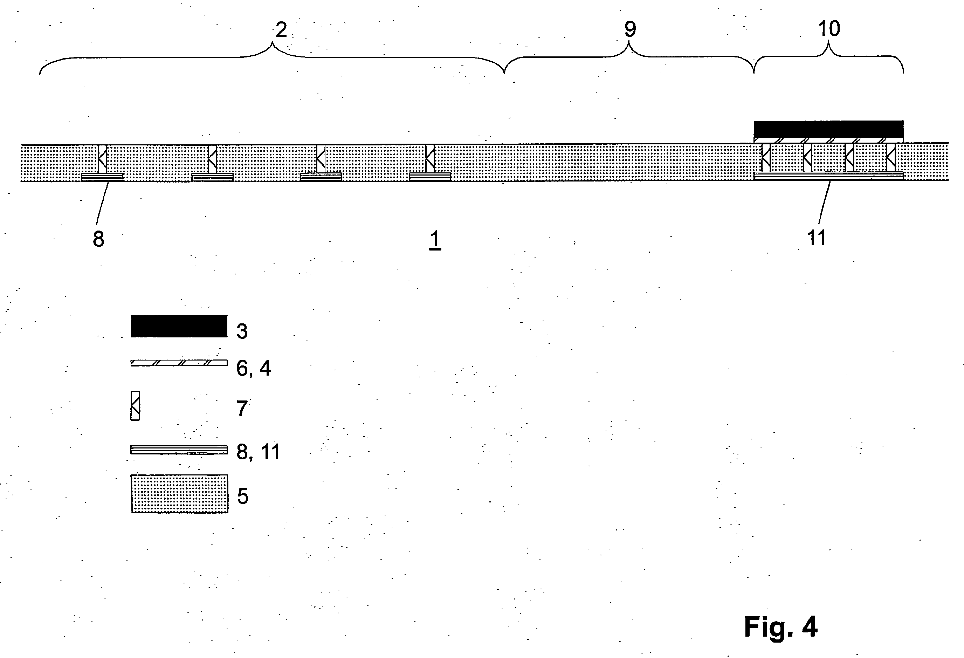

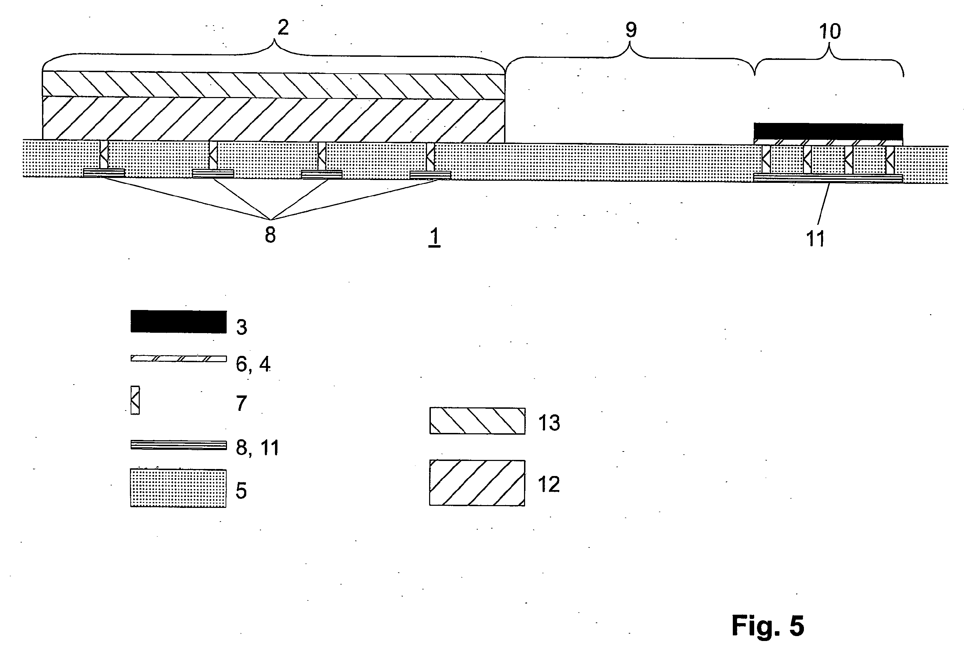

In einer Variante des erfindungsgemäßen Verfahrens wird neben der CMOS-Metallisierung 3 auch die untere Barriereschicht 6 im photoaktiven Bereich 2 entfernt (Fig. 4, 5), und die Vias 7 (z. B. W-Plugs), welche den Kontakt zum CMOS-Pixelschaltkreis herstellen, bilden hier die Pixelrückelektroden der Photodioden. Diese Variante eignet sich besonders zur Realisierung kleiner Pixel.

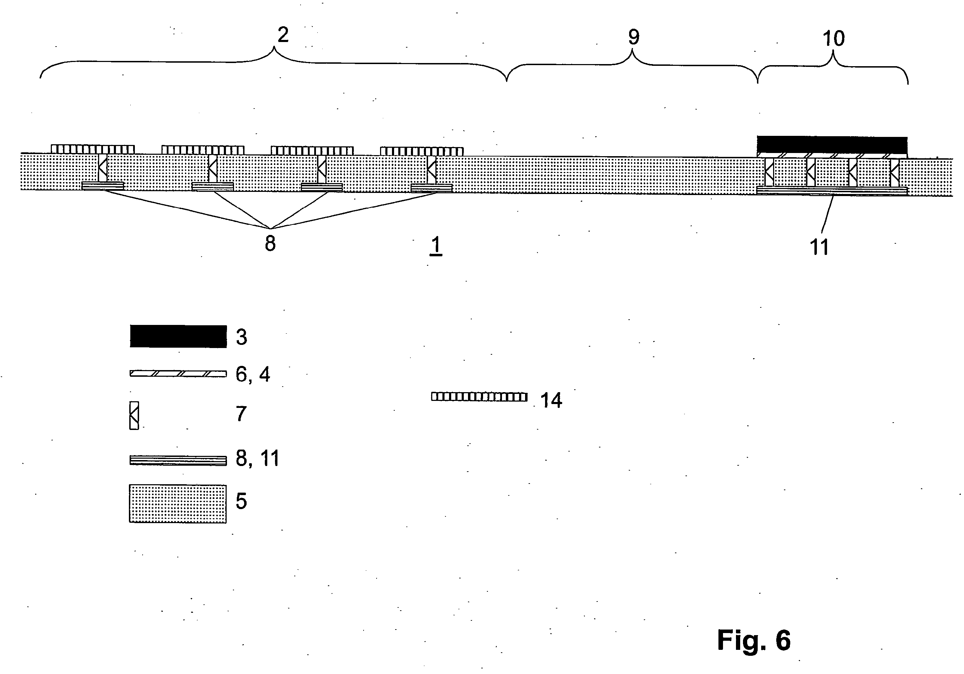

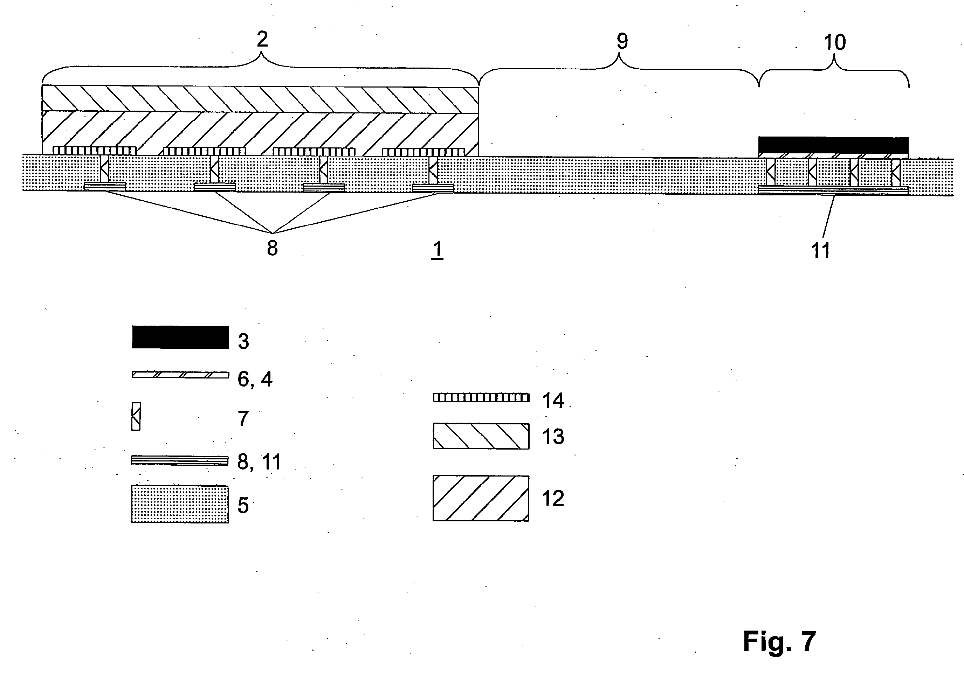

Schließlich kann in einer weiteren Variante des erfindungsgemäßen Verfahrens, aufbauend auf eine freigelegte Barriereschicht 6 oder direkt auf eine Anordnung von Vias 7 eine weitere Metallschicht 14, welche im Pixelraster strukturiert wird und als Pixelrückelektrode fungiert (Fig. 6, 7), aufgebracht werden. Für diese Metallschicht 14 bieten sich insbesondere Chrom oder Chromlegierungen an, so dass mit Hilfe dieser Konfiguration sehr niedrige Dunkelströme erzielt werden können. Auf diese Struktur wird dann die Photodiode aus amorphem oder mikrokristallinem Silizium 12 oder deren Legierungen und eine Kontaktschicht 13 aufgetragen.

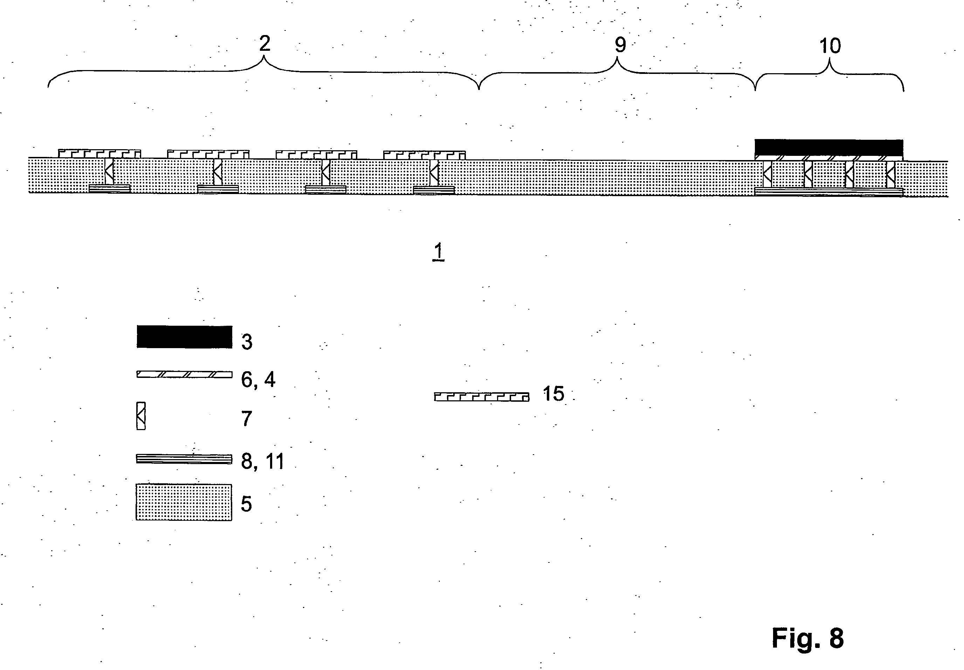

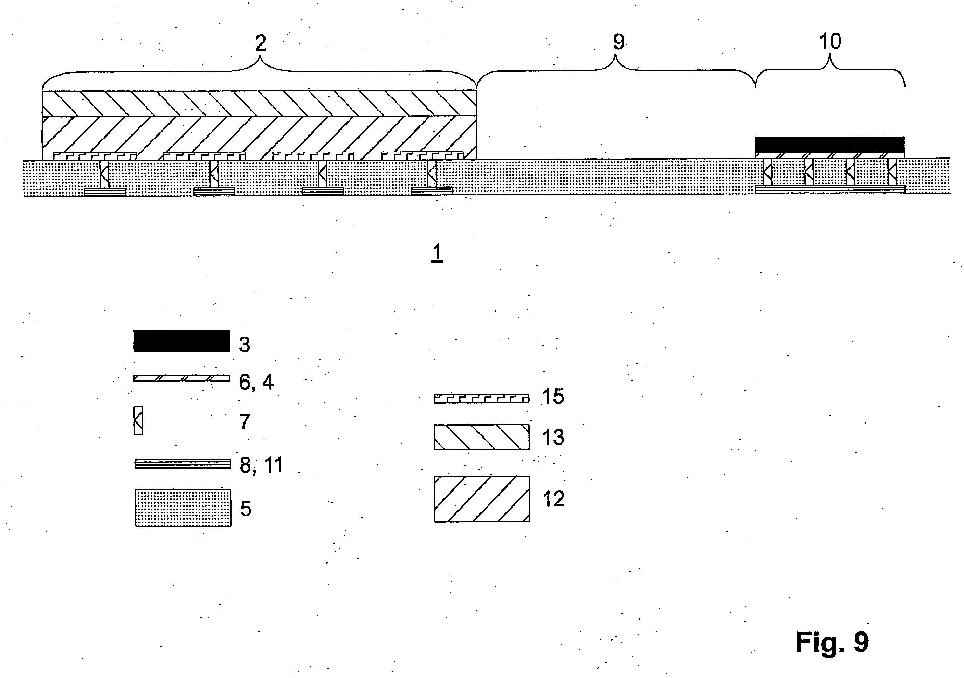

In einer anderen Variante des erfindungsgemäßen Verfahrens wird die Rückelektrode der Photodiode durch eine im Pixelraster strukturierte dotierte Schicht 15 aus amorphem oder mikrokristallinem Silizium oder deren Legierungen gebildet (Abb. 8, 9). Diese dotierte Schicht 15 kann unmittelbar auf dem Zwischenmetall-Dielektrikum 5, der unteren strukturierten Barriereschicht 6 oder der Metallschicht 14 aufgetragen werden. Auf diese Struktur wird dann die Photodiode aus amorphem oder mikrokristallinem Silizium 12 oder deren Legierungen und eine Kontaktschicht 13 aufgetragen.

Bei jeder der genannten Varianten kann die Photodiode als pin-, nip-, Schottky-Diode oder als Farbsensor aus amorphem oder mikrokristallinem Silizium oder deren Legierungen mit gegebenenfalls weiteren Materialien ausgeführt sein.

### Bezugzeichenliste

- 1: CMOS-ASIC-Schaltkreis
- 2: photoaktiver Bereich
- 3: CMOS-Metallisierung (Metall 2)
- 4: Barriereschicht
- 5: Zwischenmetall-Dielektrikum
- 6: Barriereschicht
- 7: Via
- 8: Leiterbahn (Metall 1)
- 9: Peripherieelektronik
- 10: Bondpad
- 11: Leiterbahn
- 12: amorphes oder monokristallines Silizium
- 13: Kontaktschicht (TCO)
- 14: Metallschicht (Metall 3)
- 15: dotierte Schicht

## Patentansprüche

1. Verfahren zur Herstellung einer Photodiodenkontaktierung für einen TFA-Bildsensor mit einem CMOS-ASIC-Schaltkreis (1), der mit einem Zwischenmetall-Dielektrikum (5) beschichtet worden ist und der in einem photoaktiven Bereich (2) Vias (7) im Pixelraster aufweist, die sich durch das Zwischenmetall-Dielektrikum (5) erstrecken und jeweils mit einer Leiterbahn (8) des CMOS-ASIC-Schaltkreises (1) verbunden sind, wobei auf dem Zwischenmetall-Dielektrikum (5) eine im Pixelraster strukturierte CMOS-Metallisierung (3) zwischen Barriereschichten (4, 6) angeordnet ist, **gekennzeichnet durch**
- Freilegen der CMOS-Metallisierung (3) innerhalb des photoaktiven Bereiches (2),
- Herstellen einer flachen Oberflächentopographie auf dem Zwischenmetall-Dielektrikum (5), indem mindestens die auf dem CMOS-ASIC-Schaltkreis (1) befindliche CMOS-Metallisierung (3) sowie die auf dieser befindliche Barriereschicht (4) im photoaktiven Bereiche bis mindestens auf die strukturierte untere Barriereschicht (6) entfernt wird, und
- anschließendes Aufbringen eines an sich bekannten amorphen oder monokristallinen Siliziums (12) sowie darüber einer an sich bekannten leitfähigen transparenten Kontaktschicht (13) auf dem Zwischenmetall-Dielektrikum (5).

2. Verfahren nach Anspruch 1, **dadurch gekennzeichnet, dass** im Bereich des photoaktiven Bereiches (2) die CMOS-Metallisierung (3) und die unter dieser befindliche Barriereschicht (6) entfernt wird, so dass das Zwischenmetall-Dielektrikum (5) mit den darin eingebetteten Vias (7) frei liegt und danach das amorphe oder monokristalline Silizium (12) [Korrektur, weil die Photodiode aus mehr als dieser Schicht besteht} und die leitfähige transparente Kontaktschicht (13) aufgebracht wird.

3. Verfahren nach Anspruch 1 oder 2, **dadurch gekennzeichnet, dass** auf dem Zwischenmetall-Dielektrikum (5) eine im Pixelraster strukturierte Metallschicht (14) aufgebracht wird.

4. Verfahren nach Anspruch 1, **dadurch gekennzeichnet, dass** auf der Barriereschicht (6) eine im Pixelraster strukturierte Metallschicht (14) aufgebracht wird.

5. Verfahren nach Anspruch 3 und 4, **dadurch gekennzeichnet, dass** die Metallschicht (14) aus Chrom hergestellt wird.

6. Verfahren nach Anspruch 3 und 4, **dadurch gekennzeichnet, dass** die Metallschicht (14) aus einer Chromlegierung hergestellt wird.

7. Verfahren nach Anspruch 1 oder 2, **dadurch gekennzeichnet, dass** auf dem Zwischenmetall-Dielektrikum (5) eine im Pixelraster strukturierte dotierte Schicht (15) aus Silizium aufgebracht wird.

8. Verfahren nach Anspruch 1, **dadurch gekennzeichnet, dass** auf der Barriereschicht (6) eine im Pixelraster strukturierte dotierte Schicht (15) aus Silizium aufgebracht wird.

9. Verfahren nach einem der Ansprüche 1 bis 8, **dadurch gekennzeichnet, dass** die dotierte Schicht (15) aus Silizium nach dem Aufbringen der im Pixelraster strukturierten Metallschicht (14) aufgebracht wird.

10. Verfahren nach einem der Ansprüche 7 bis 9, **dadurch gekennzeichnet, dass** die dotierte Schicht (15) aus amorphem Silizium oder Legierungen davon hergestellt wird.

11. Verfahren nach einem der Ansprüche 7 bis 9, **dadurch gekennzeichnet, dass** die dotierte Schicht (15) aus einem mikrokristallinem Silizium, oder Legierungen davon hergestellt wird.

## Claims

1. Method for producing a photodiode contact for a TFA image sensor, comprising a CMOS-ASIC circuit (1) that has been coated with an intermediate metal dielectric component (5) and has vias (7) in a photoactive zone (2), which are arranged in a pixel grid, extend through the intermediate metal dielectric component (5) and are linked with a respective strip conductor (8) of the CMOS-ASIC circuit (1), wherein on the intermediate metal dielectric component (5) a pixel-grid structured CMOS metallization (3) is arranged between barrier layers (4, 6),
**characterized by**
- exposing the CMOS metallization (3) in the area of the photoactive zone (2),
- producing a flat surface topography on the intermediate metal dielectric component (5) by removing at least the CMOS metallization (3) present on the CMOS-ASIC circuit (1) as well as the barrier layer (4) present thereon in the photoactive zone, except for at least the structured lower barrier layer (6), and
- subsequently applying a known amorphous or monocrystalline silicon (12) as well as a known conductive transparent contact layer (13) to the intermediate metal dielectric component (5).

2. Method according to Claim 1, **characterized in that** in the area of the photoactive zone (2) the CMOS metallization (3) and the barrier layer (6) present therebelow are removed, so that the intermediate metal dielectric component (5) with the vias (7) embedded therein is exposed and afterwards the amorphous or monocrystalline silicon (12) [correction because the photodiode consists of more than this layer] and the conductive transparent contact layer (13) are applied.

3. Method according to Claim 1 or 2, **characterized in that** a pixel-grid structured metal layer (14) is applied to the intermediate metal dielectric component (5).

4. Method according to Claim 1, **characterized in that** a pixel-grid structured metal layer (14) is applied to the barrier layer (6).

5. Method according to Claims 3 and 4, **characterized in that** the metal layer (14) is made from chrome.

6. Method according to Claims 3 and 4, **characterized in that** the metal layer (14) is made from a chromium alloy.

7. Method according to Claim 1 or 2, **characterized in that** a pixel-grid structured, doped layer (15), made from silicon, is applied to the intermediate metal dielectric component (5).

8. Method according to Claim 1, **characterized in that** a pixel-grid structured, doped layer (15), made from silicon, is applied to the barrier layer (6).

9. Method according to any one of Claims 1 to 8, **characterized in that** the doped layer (15), made from silicon, is applied, after the pixel-grid structured metal layer (14) has been applied.

10. Method according to any one of Claims 7 to 9, **characterized in that** the doped layer (15) is made from amorphous silicon or alloys thereof.

11. Method according to any one of Claims 7 to 9, **characterized in that** the doped layer (15) is made from a micro-crystalline silicon, or alloys thereof.

## Revendications

1. Procédé de production d'une mise en contact de photodiode pour un capteur d'image TFA avec un circuit de commutation CMOS - ASIC (1), revêtu d'un diélectrique en métal intermédiaire (5) et présentant dans une zone photoactive (2) des contacts (7) dans la grille de pixels, qui s'étendent à travers le diélectrique en métal intermédiaire (5) et sont reliés chacun à une piste conductrice (8) du circuit de commutation CMOS - ASIC (1), et une métallisation CMOS (3) structurée dans la grille de pixels est disposée sur le diélectrique en métal intermédiaire (5) entre des couches de barrière (4, 6),
**caractérisé par**
- l'enlèvement de la métallisation CMOS (3) à l'intérieur de la zone photoactive (2),
- la réalisation d'une topographie de surface plane sur le diélectrique en métal intermédiaire (5), en retirant au moins la métallisation CMOS (3) située sur le circuit de commutation CMOS - ASIC (1) ainsi que la couche de barrière (4) située sur celle-ci dans la zone photoactive au moins jusqu'à la couche de barrière inférieure (6) structurée, et
- ensuite l'application d'un silicium amorphe ou monocristallin (12) connu en lui-même ainsi que d'une couche de contact transparente conductrice (13) connue en soi sur le diélectrique en métal intermédiaire (5).

2. Procédé selon la revendication 1,
**caractérisé en ce qu'**
on retire dans la zone de la zone photoactive (2) la métallisation CMOS (3) et la couche de barrière inférieure (6) située sous celle-ci, si bien que le diélectrique en métal intermédiaire (5) est dénudé, avec les contacts (7) intégrés dans celui-ci, et on applique ensuite le silicium amorphe ou monocristallin (12) [correction parce que la photodiode est composée de plus que cette couche] et la couche de contact transparente conductrice (13).

3. Procédé selon la revendication 1 ou 2,
**caractérisé en ce qu'**
une couche de métal (14) structurée dans la grille de pixels est appliquée sur le diélectrique en métal intermédiaire (5).

4. Procédé selon la revendication 1,
**caractérisé en ce qu'**
une couche de métal (14) structurée dans la grille de pixels est appliquée sur la couche de barrière (6).

5. Procédé selon les revendications 3 et 4,
**caractérisé en ce que**
la couche de métal (14) est en chrome.

6. Procédé selon les revendications 3 et 4,
**caractérisé en ce que**
la couche de métal (14) est en un alliage de chrome.

7. Procédé selon la revendication 1 ou 2,
**caractérisé en ce qu'**
une couche (15) de silicium dopée structurée dans la grille de pixels est appliquée sur le diélectrique en métal intermédiaire (5).

8. Procédé selon la revendication 1,
**caractérisé en ce qu'**
une couche (15) de silicium dopée structurée dans la grille de pixels est appliquée sur la couche de barrière (6).

9. Procédé selon l'une des revendications 1 à 8,
**caractérisé en ce que**
la couche (15) de silicium dopée est appliquée après l'application de la couche de métal (14) structurée dans la grille de pixels.

10. Procédé selon l'une des revendications 7 à 9,
**caractérisé en ce que**
la couche (15) dopée est réalisée en silicium amorphe ou en alliages de celui-ci.

11. Procédé selon l'une des revendications 7 à 9,
**caractérisé en ce que**
la couche (15) dopée est réalisée en silicium microcristallin ou en alliages de celui-ci.
